# EUROPEAN PATENT SPECIFICATION

(11) **EP 0 786 929 B1**
(45) Date of publication and mention of the grant of the patent: **07.08.2002**
(21) Application number: 97105523.1
(22) Date of filing: 28.08.1991
(51) Int. Cl.: H05K 7/14, H01R 13/62, H01R 13/633, H01R 12/18, G06K 13/08

(54) **Connector apparatus for IC packages**
Verbinderanordnung für IC-Packungen
Dispositif de connexion pour des empaquetages de circuits intégrés

(30) Priority: 31.08.1990 JP 9077290
(43) Date of publication of application: 30.07.1997
(62) Divisional of application: 91307886.1
(73) Proprietor: BERG ELECTRONICS MANUFACTURING B.V., 5222 AV s'-Hertogenbosch (NL)
(72) Inventor: Abe, Hiroshi, Midori-ku, Yokohama-shi (US); Narita, Hiroshi, Meguro-ku, Tokyo (US); Takahashi, Ryosuke, Miyamae-ku, Kawasaki-shi (US)
(74) Representative: Barnard, Eric Edward

(56) References cited:
- GB-A- 2 205 000
- US-A- 4 952 161

## Description

This invention relates to a connector apparatus for plate-like IC packages, more particularly, to a connector apparatus for receiving and ejecting a memory card which is connected to CPU, DMA, or the like, in a electronic device for reading out data stored in the package to perform predetermined tasks.

In an electronic device, such as a microcomputer, it has been common practice to mount an IC package, such as a memory card, in an electronic device body, if necessary, in an electrically connected fashion so as to accomplish, for example, an extended application. For this purpose, a connector apparatus has been used in the art.

The conventional connector apparatus for an IC package is of such a type that it has a substantially U-shaped frame with a pair of guide grooves provided on its inner side frame portions and a connector section provided as a connection frame portion between the side frame portions and, in use, a plate-like IC package is inserted via an access hole into the device space, while being guided along the guide grooves, and held there with its array of socket terminals electrically connected to an associated pin terminal array of the connector section.

In a recent trend toward thin, lightweight compact electronic devices, there is a demand for a corresponding compact connector which receives an IC package into its storage space and holds the package electrically connected with the electronic device.

One known IC-pack connector apparatus according to the preamble of claim 1 having an ejecting function is described in GB-A-2205000.

In the known types of connector apparatus for IC packages, in order to prevent deformation due to loading the lever has to be relatively thick and, further, a strong structure needs to be provided at the fulcrum site. It is thus not possible to make the connector thinner in the direction of the thickness of the package and the connector is not particularly compact.

It is accordingly an object of the present invention to provide a connector apparatus for plate-like IC packages, which takes the form of a thin, lightweight compact unit, closely equal to the dimensions of the package per se and which is very durable in spite of its thin structure.

A connector apparatus constructed in accordance with the invention as defined in claim 1 comprises:
a pair of guide frame members spaced apart so as to be suitable to guide a plate-like IC package;
a connector section disposed at one end of the guide frame members and having connecting pins to be electrically connected to said package, said connector section being detachably connected to the guide frame members;
a displaceable pull-out plate member having engaging hook means engageable with a forward end of said package electrically connected to the connector section and
an ejection lever coupled to the pull-out plate member, the lever being pivotable to cause the pull-out plate member to be displaced to eject the package, wherein the ejection lever is coupled to the pull-out plate member with the aid of a raised section on the lever engaging with a raised claw of the pull-out plate member.

This invention may be more fully understood from the following detailed description taken in conjunction with the accompanying drawings, in which:
Fig. 1 is a plan view showing one embodiment of the present invention;
Fig. 2 is a bottom view showing the embodiment of the present invention;
Fig. 3 is a cross-sectional view showing a journal support structure of an ejection lever in the embodiment of the present invention; and
Fig. 4 is a side view showing the embodiment of the present invention.

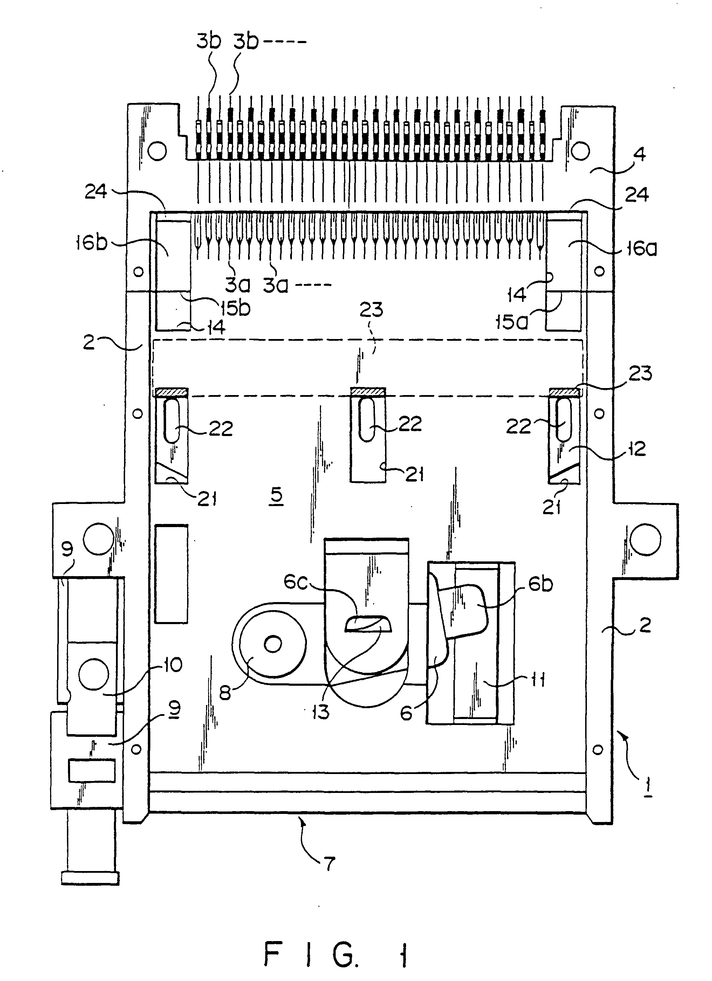

Fig. 1 is a plan view showing a connector apparatus 1 according to one embodiment of the present invention, the arrangement shown in this Figure normally corresponding to a "circuit board" side in an electronic device for reading data stored in the package.

The connector apparatus 1 comprises a pair of guide frame members 2, made of a resin such as a nylon, spaced apart by a distance somewhat greater than the width of a plate-like IC package (memory card), not shown. The members 2 each have a length substantially equal to the depth of the package and a thickness substantially equal to the thickness of the package. The members 2 adjoin a connector section 4 having connecting pins 3a for fitting into socket terminals provided on the package and connecting pins 3b at the external side for connection to the device. A housing plate member 5, made of a metal, fixes the guide frame members 2 in place. The guide frame members 2 are secured to the plate 5 with screws 25. The plate 5 has a later-described ejection mechanism formed on its surface, and, upon being mounted in place in the electronic device, defines with the guide frame members 2, a storage space for the package which space has an access hole 7 opposite the connector section 4

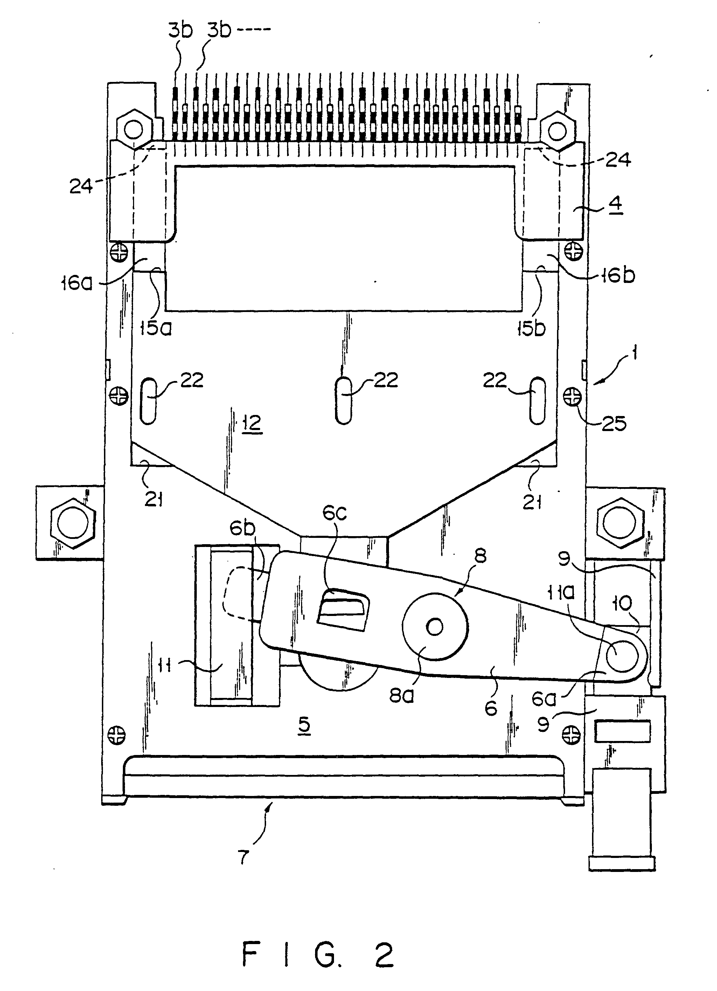

Fig. 2 is a bottom view of the connector apparatus 1 as seen from the rear side as distinct from the side shown in Fig. 1, the ejection mechanism being principally shown in Fig. 2. The ejection mechanism employs an ejection lever or arm 6 made of a metal and supported by a journal or shaft 8 on the lower surface side of the housing plate 5 at an area near the access hole 7 leading to the package storage space. In order to pivot the ejection lever 6 around the journal 8, one end 6a of the ejection lever 6 is pivotably coupled with another journal or shaft 11a to one end of a slide member 10 which is slidably movable in a one-piece moulded guide 9 at the outer side of one of the guide frame members 2. A tongue 6b is provided integral with the other end of the ejection lever 6. The tongue 6b is located in slidable contact with the inside surface of the band-like guide 11 somewhat raised from the housing plate 5. Thus, the ejection lever 6 is so constructed as to be pivotable in a plane parallel to the housing plate 5. The ejection lever 6 has a raised section 6c projecting toward the housing plate 5.

Reference numeral 12 signifies a pull-out metal conductive plate which can withdraw the package (not shown) out of electrical connection with the connector section 4 of the connector device 1 when the package is not in use. The pull-out plate 12 has a raised engaging claw 13, at its end and is coupled with or engages with the raised section 6c formed on the driven side of the lever 6 as distinct from the drive side 8 of the lever 6. The pull-out metal plate 12 is of such a type that it is slidable in a pull out direction of the package over the housing plate 5 upon pivoting of the ejection lever 6. The pull-out metal plate 12 has extending arms 16a and 16b one at each opposite side. The pull-out metal plate 12 further has bent sections 15a, 15b in a stepped relation such that their forward ends are upwardly projected via cutouts 14, provided at the corresponding areas of the housing plate 5. The forward ends of the arms 16a and 16b are bent to provide engaging hooks 24 engaging with a socket-side end face, that is, the forward end face, of the IC package. Thus the package stored in the storage space of the connector apparatus 1 has its surface placed in direct contact with the arms 16a and 16b of the pull-out plate 12.

The package needs to be electrically shielded and, in order to achieve this, three projections 22 are provided at corresponding places, by an extrusion molding method, in the middle portion of the pull-out metal plate 12 such that they project toward the storage space via through holes 21 provided at the corresponding areas of the housing plate 5 to allow them to contact the outer surface of the inserted IC package.

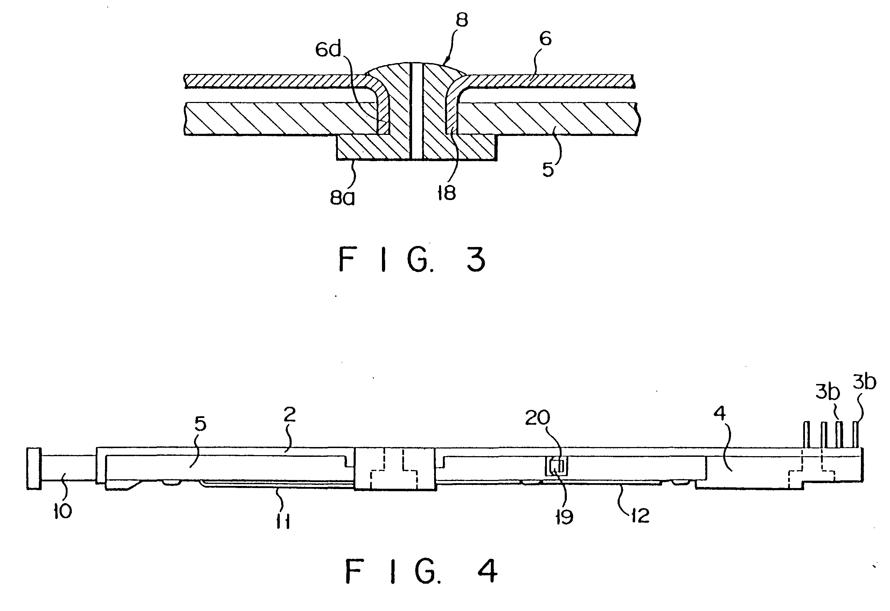

Fig. 3 is a cross-sectional view showing one of the journal support structures of the ejection lever 6. Since the journal support structures for the shafts 8 and 11a are of the same type, only one journal support structure for the shaft 8 will be explained below in conjunction with Fig. 3. As shown in Figure 3, a tubular projection 6d is provided on the ejection lever 6 and is made of, for example, a stainless steel. The tubular projection 6d is fitted in a bearing hole 18 provided in the housing plate 5 and made of, for example, a stainless steel. The shaft 8, made of brass, has a flange 8a at one end and is fitted in a center through hole provided in the tubular projection 6d. The other end of the shaft 8 remote from the flange 8 is caulked-in to prevent the shaft 8 from becoming detached. The projection 6d is rotatable in the bearing hole 18 in accordance with the movement of the lever 6. The ejection lever 6 can be repeatedly pivoted as the IC package is fitted and removed and the outer surface of the tubular projection 6d of the ejection lever 6 makes bearing contact with the inner wall surface of the bearing hole 18 in the housing plate 5. Since the housing plate 5 is made of the same material as that of the ejection lever 6, it is possible to achieve a high wear resistance and hence to achieve a remarkably enhanced endurance at the bearing surfaces.

The problem with the endurance of the bearing has hitherto arisen from, for example, clearance between the shaft and the insertion hole of the ejection lever due to, for example, wear and a resultant reduction in an IC package pullout stroke length. That is a reliability problem has been involved after repeated withdrawal of the package.

It has been found that the aforementioned bearing or journal structure of the ejection lever 6 of the connector apparatus according to the embodiment of the present invention can fully withstand about 20,000 ejection operations, a figure which is generally required in this field of art.

Further, the connector apparatus of the present embodiment is such that the connector section 4 can be separated from the ejection mechanism-equipped housing plate 5 side by a simple operation. Fig. 4 is a side view showing the connector apparatus. In Fig. 4, an engaging arm, not shown, is provided integral with each side section of the connector section 4 made of elastic material and an engaging projection 19 is provided on the forward end of each engaging arm. Each engaging arm of the connector section 4 is inserted into a reception space provided between a bent side portion of the housing plate 5 and a recess formed at the side surface of the associated guide frame member 2. The engaging projection 19 of each arm is fitted into a hole 20 provided in the associated bent side portion of the housing plate 5. Thus, the connector section 4 can be freely and readily attached to, or detached from, the rest of the apparatus by bringing the engaging projections 19 of the engaging arms of the connector section 4 into and out of engagement with the engaging holes 20.

When the package is mounted in the apparatus according to the present invention, it is inserted into the storage space via the access hole 7 of the connector apparatus 1 to fit the socket terminals of the package over the pins 3a of the connector section 4. At this time, the forward end face of the package engages with the engaging hooks 24, 24 of the pull-out metal plate 12 to move the metal plate 12 in a forward direction. As a result, the ejection lever 6 is pivoted around the axis of the journal 8, causing the slider member 10 to be displaced.

With the package held in the storage space, the IC package is grounded through the pull-out plate 12 whose projections 22 are connected via the through holes 21 of the housing plate 5 to the package surface and then through the ejection lever 6, the housing plate 5 and screws 25.

By so doing, it is only necessary that only one surface of the package, that is, only its surface facing the housing plate 5, make electrical contact with the projections 22 of the pull-out plate 12. Therefore, no particular consideration needs to be paid to the other surface of the package which faces the circuit board. It is thus possible to provide a desired printed circuit pattern, for example, on that surface.

Further, since there is no intervening object between the circuit board and the one surface of the package, electric contact can be made between the side of the package and the circuit board and this can be so done at any proper position with the use of a thin metal plate of, for example, a predetermined electric conductivity. It is possible to properly print a desired circuit pattern on each side of the package.

When the package is to be withdrawn out of the storage space, the slider member 10 is pushed, causing the ejection lever 6 to be pivoted around the rotating axis the Journal 8. This action causes the pull-out plate 12 to be moved over the surface of the housing plate 5 along the guide frame members 22 with the raised section 6c hooked by the engaging claw 13, so that the package is withdrawn out of the storage space through the utilization of the engaging hooks 24, 24 on the forward end of the arms 16a, 16b.

In the aforementioned connector apparatus 1, the pull-out plate 12 is freely moved over the surface of the housing plate 5 and, if a deburring process which should be done, for example, at the edge of the punched through hole 21 of the housing plate 5 is omitted so as to lower the manufacturing cost, then there is a possibility that the contacting surface of the draw-out plate 12 will be scraped by the burr. It is preferable that, in order to prevent the occurrence of electrical faults resulting from the drop of the metal scrapings onto the package or connector section, a plate-like covering 23 made of, for example, polyethylene be joined to that area of the pull out plate 12 where the draw-out plate 12 is moved over the through holes of the housing plate 5.

The connector apparatus according to the present embodiment has a dimension, that is, a thickness about 1.4 times that (about 3 mm) of the package, a width corresponding to a total of the width of the package plus that of the guide frame member 2, and a depth greater than the depth of both the depth of the package and thickness of the engaging hook 24 involved upon engagement of the engaging hooks 24 with the socket-side end face of the package. It is thus possible to obtain a thin compact unit.

As will be evident from the above, the connector apparatus of the present invention can be achieved with much less number of component parts than a conventional connector apparatus for IC package of the same type. It is thus possible to make the whole outer dimension of the connector apparatus closely equal to that of the package per se and hence to provide a thin, durable compact connector apparatus.

## Claims

1. A connector apparatus for use with plate-like IC packages, said apparatus comprising:
a pair of guide frame members (2) spaced apart so as to be suitable to guide a plate-like IC package;
a connector section (4) disposed at one end of the guide frame members (2) and having connecting pins (3a) to be electrically connected to said package;
a displaceable pull-out plate member (12) having engaging hook means (24) engageable with a forward end of said package electrically connected to the connector section (4) and
an ejection lever (6) coupled to the pull-out plate member (12), the lever (6) being pivotable to cause the pull-out plate member (12) to be displaced to eject the package, **characterised in that** said connector section (4) is detachably connected to the guide frame members (2) and the ejection lever (6) is coupled to the pull-out plate member (12) with the aid of a raised section (6c) on the lever (6) engaging with a raised claw (13) of the pull-out plate member (12).

2. A connector apparatus according to claim 1, wherein the guide frame members (2) are made of a resin; and the pull-out plate member (12) and the ejection lever (6) are made of a metal.

## Patentansprüche

1. Verbindervorrichtung zur Verwendung mit plattenartigen IC-Baueinheiten, wobei diese Vorrichtung umfaßt:
ein Paar Führungsrahmenelemente (2), die so in einem Abstand voneinander angeordnet sind, daß sie sich zur Führung einer plattenartigen IC-Baueinheit eignen;
einen Verbinderteil (4), der an einem Ende der Führungsrahmenelemente (2) angeordnet ist und Verbindungsstifte (3a) zur elektrischen Verbindung mit der Baueinheit aufweist;
ein verschiebbares Ausziehplattenelement (12), das Mitnehmerhakenmittel (24) aufweist, die mit einem vorderen Ende der mit dem Verbinderteil (4) elektrisch verbundenen Baueinheit in Eingriff gebracht werden können; und
einen Auswurfhebel (6), der mit dem Ausziehplattenelement (12) gekuppelt ist, wobei der Hebel (6) schwenkbar ist, um zu bewirken, daß das Ausziehplattenelement verschoben wird, um die Baueinheit auszuwerfen;
**dadurch gekennzeichnet, daß** der Verbinderteil (4) lösbar mit den Führungsrahmenelementen (2) verbunden ist und der Auswurfhebel (6) mittels eines erhabenen Teils (6c) auf dem Hebel (6), der mit einer erhabenen Klaue (13) des Ausziehplattenelements (12) in Eingriff ist, mit dem Ausziehplattenelement (12) gekuppelt ist.

2. Verbindervorrichtung nach Anspruch 1, wobei die Führungsrahmenelemente (2) aus einem Harz gefertigt sind und das Ausziehplattenelement (12) und der Auswurfhebel (6) aus einem Metall gefertigt sind.

## Revendications

1. Dispositif de connexion à utiliser avec des empaquetages de circuits intégrés sous forme de plaquette, ledit dispositif comprenant :
une paire d'éléments de structure de guidage (2) distants de façon à être appropriée pour guider un empaquetage de circuits intégrés sous forme de plaquette ;
une section de connexion (4) disposée à une extrémité des éléments de structure de guidage (2) et comportant des broches de connexion (3a) à connecter électriquement audit empaquetage ;
un élément mobile de plaque d'extraction (12) comportant des moyens de crochet d'engagement (24) pouvant s'engager avec une extrémité avant dudit empaquetage connecté électriquement à la section de connexion (4) et
un levier d'éjection (6) couplé à l'élément de plaque d'extraction (12), le levier (6) pouvant pivoter pour entrainer l'élément de plaque d'extraction (12) à être déplacé afin d'éjecter l'empaquetage, **caractérisé en ce que** ladite section de connexion (4) est connectée de façon détachable auxdits éléments de structure de guidage (2) ; et **en ce que** le levier d'éjection (6) est couplé à l'élément de plaque d'extraction (12) à l'aide d'une section en relief (6c) formée sur le levier (6) coopérant avec un ergot vertical (13) de l'élément de plaque d'extraction (12).

2. Dispositif de connexion selon la revendication 1, dans lequel les éléments de structure de guidage (2) sont constitués de résine ; et l'élément de plaque d'extraction (12) et le levier d'éjection (6) sont en métal.
